# EUROPEAN PATENT SPECIFICATION

(11) **EP 2 573 451 B1**
(45) Date of publication and mention of the grant of the patent: **29.11.2017**
(21) Application number: 12182835.4
(22) Date of filing: 03.09.2012
(51) Int. Cl.: F21K 9/64, F21K 9/90, F21Y 113/13, F21Y 105/00, F21Y 115/10

(54) **Selection of Phosphors and LEDS in a Multi-Chip Emitter for a Single White Color Bin**
Auswahl von Leuchtstoffen und LEDS in einem Mehrchipsender für eine weiße Einzelfarbklassifizierung
Sélection de phosphores et DEL dans un émetteur à puces multiples pour un seul bac de couleur blanche

(30) Priority: 22.09.2011 US 201113240796
(43) Date of publication of application: 27.03.2013
(73) Proprietor: Ledengin, Inc., Santa Jose, CA 95134 (US)
(72) Inventor: Yan, Xiantao, San Jose, CA 95134 (US); Lee, Kachun, San Jose, CA 95134 (US)
(74) Representative: Barnfather, Karl Jon

(56) References cited:
- EP-A2- 2 334 147
- WO-A1-2007/049187
- US-A1- 2003 214 817
- US-A1- 2006 057 753
- US-A1- 2009 303 694
- US-A1- 2010 244 731
- US-A1- 2011 037 080

## Description

### BACKGROUND

The present invention relates in general to lamps based on light-emitting diodes (LEDs) and in particular to selection of phosphors and LED dies for a multi-die emitter to support tuning of the emitter to a single white color bin.

With the incandescent light bulb producing more heat than light, the world is eager for more efficient sources of artificial light. LEDs are a promising technology and are already widely deployed for specific purposes, such as traffic signals and flashlights. However, the development of LED-based lamps for general illumination has run into various difficulties. Among these is the difficulty of mass-producing lamps that provide a consistent color temperature.

As is known in the art, not all white light is the same. The quality of white light can be characterized by a color temperature, which ranges from the warm (slightly reddish or yellowish) glow of standard tungsten-filament light bulbs to the cool (bluish) starkness of fluorescent lights. Given existing processes for LED manufacture, mass-producing white LEDs with a consistent color temperature has proven to be a challenge.

Various solutions have been tried. For example, white LEDs can be binned according to color temperature and the LEDs for a particular lamp can be selected from the desired bin. However, the human eye is sensitive enough to color-temperature variation that a large number of bins is required, with the yield in any particular bin being relatively low.

Another solution relies on mixing different colors of light to produce a desired temperature. For example, an LED lamp can include a number of white LEDs plus some red LEDs. The brightness of the red LEDs can be increased to warm the light to the desired color temperature. Such lamps generally require an active feedback mechanism to maintain the color temperature, in part because the LEDs used are not stable in their color characteristics over time. The active feedback mechanism requires a sensor to detect the light being produced, an analyzer to determine whether the light is at the desired color, and an adjustment mechanism to adjust the relative brightness of the white and red LEDs as needed to maintain the desired color. These feedback-loop elements can be a weak point in the system; for example, if the light sensor drifts over time (as most do), so will the color of the light. In addition, incorporating active feedback components into a lamp drives up the cost of manufacturing (and operating) the lamp.

US 2009/303694 provides a light emitting device comprising a first light emitting portion that emits white light at a color temperature of 6000K or more and a second light emitting portion that emits white light at a color temperature of 3000K or less, which include light emitting diode chips and phosphors and are independently driven. EP2334147A2 discloses a prior art LED illumination device including a control device for controlling an optical output ratio of a plurality of light emitting devices of different emission colors.

### SUMMARY

Embodiments of the present invention relate to selection of LED dies and phosphors to be used in multi-die emitters to produce light that can be tuned to a single white color bin. The emitter is advantageously designed such that different groups of the LEDs are independently addressable, that is, the current delivered to each group is separately controllable. Such an emitter allows the net color of light produced by a lamp in which the emitter is included to be tuned to a color intermediate between the colors produced by the different groups of LEDs, e.g., by adjusting the relative current delivered to different groups.

To produce a desired white color (e.g., white light having a particular color temperature), the LED dies and a phosphor-containing element for each die can be selected such that one of the independently-addressable groups of LEDs produces a warmer white light than the desired color while another of the groups produces a cooler white light than the desired color, with the desired white color being intermediate between the warmer and cooler color temperatures so that the lamp can be tuned to the desired white color. In some embodiments, individual LED dies of a specified color, e.g., blue, are binned according to a particular spectral characteristic (e.g., peak wavelength) of the light produced by the LED die. Phosphor-containing elements can be provided as "chips" made of a solid matrix material in which are dispersed phosphorescent chemicals (e.g., conventional yellow, green, and/or red phosphors) at a known concentration; a variety of different "types" of phosphor chip can be provided, with each type being characterized, e.g., by thickness, combination (mixture) of phosphorescent chemicals, and/or concentration (density) of phosphorescent chemicals relative to matrix material. Phosphor chips can be made by producing a large sheet of phosphor-containing material and cutting the sheet into chips, with each chip having an area approximately equal to the top surface area of an LED die.

A blue LED die, when covered by a phosphor chip containing predominantly yellow phosphors, can produce white light. The particular color (or color temperature) of the white light depends, in a reproducible manner, on the initial wavelength (and/or other spectral characteristics) of the blue light and the particular characteristics, or chip type, of the phosphor chip. Given a finite number of types of phosphor chips and blue LED dies sorted into die types based on spectral properties (e.g., peak wavelength) into a finite number of color bins, a finite number of die-type/phosphor-type combinations are possible. The color produced by each combination can be determined, e.g., by measuring samples of each. Using this color data, it is possible to select a set of LED dies for a multi-die emitter and a phosphor chip for each LED die such that the white color bin intended for a lamp containing the emitter is intermediate between a "warm white" color produced by one group of the LEDs and a "cool white" color produced by another group of the LEDs. Thus, the emitter can be designed such that the lamp will be tunable to a specific desired white color bin. The white color bin can be defined as a relatively small region in color space, such that variations in color between lamps in the bin are imperceptible or nearly so.

The selection of the LEDs and phosphors for a multi-die emitter can be automated. For example, based on a color measurement of light produced by a number of test samples of various combinations of LED die type and phosphor-chip type, a look-up table can be constructed that associates each combination with the color of light produced. Once the table is constructed, it can be used to select, for a given emitter with LED dies of known peak wavelengths (or other spectral characteristics), an appropriate phosphor chip for each LED die such that each group of independently addressable LEDs produces light of the color temperature desired for that group.

Certain aspects of the present invention relate to light-emitting devices. Such devices can include a substrate with multiple LED dies arranged on a surface of the substrate and multiple phosphor chips disposed such that each phosphor chip covers a light-emitting surface of a different one of the LED dies. The LED dies are electrically connected to form at least two independently addressable groups of LEDs, including a first group to produce light whose color is in a first region of a color space (e.g., a warm white region) and a second group to produce light whose color is in a second region of the color space (e.g., a cool white region) that does not overlap with the first region. Some embodiments may include one or more additional groups of LEDs (e.g., a red group, a green group, or a second warm white or cool white group); all groups advantageously produce light in non-overlapping regions in color space. The phosphor chips covering each of the LED dies is individually selected based on a known spectral characteristic (e.g., peak wavelength) of light produced by the given LED die and the color of the light to be produced by the group in which the given LED die is included.

In some embodiments, the LED dies are blue LED dies (emitting light primarily or entirely in a blue region of the electromagnetic spectrum) and the phosphor chips contain at least a yellow phosphor. The phosphor chips advantageously differ from each other in at least one of chip thickness, concentration of phosphorescent material contained therein, or mixture (or composition) of phosphorescent materials contained therein.

Certain aspects of the invention relate to methods for making a light-emitting device. For example, a color bin for the light-emitting device can be determined. An emitter substrate can be provided; the substrate advantageously has multiple locations for connecting light-emitting diodes (LEDs) and provides electrical connections between the locations such that the LED locations are arranged into at least two independently addressable groups. A source region in a color space is selected to be associated with the independently addressable group such that the color bin for the device is intermediate between the source regions in the color space and such that the source regions for different groups are non-overlapping; for instance, a warm white source region and a cool white source region can be selected. For each LED location, an LED die (e.g., a blue LED die) and a phosphor chip (e.g., a yellow-phosphor-containing chip) are selected such that the LED die and the phosphor chip together produce light in the source region associated with the independently addressable group to which the LED location belongs. The selected LED dies and phosphor chips are mounted on the emitter substrate at the LED locations. For instance, a pick-and-place system can be operated to place the selected LED dies and phosphor chips onto the emitter substrate. In some embodiments, the selected LED dies are first placed on and electrically connected to the substrate, after which the phosphor chips are attached to the LED dies, e.g., by applying an adhesive to the top surfaces of the LED dies and placing the phosphor chips on the adhesive.

In some embodiments, selecting the LED die and the phosphor chips includes selecting a phosphor chip type from a number of options; the various phosphor chip types can differ from each other in one or more of chip thickness, concentration of phosphorescent material, and/or mixture (or composition) of phosphorescent materials. Selecting the LED die and the phosphor chips may include selecting a wavelength bin for the LED die.

Certain aspects of the invention relate to apparatus for assembling a light-emitting device. Such an apparatus can include a robotic pick-and-place system to select LED dies and phosphor chips from a component tray and place the selected LED dies and phosphor chips on an emitter substrate; the component tray advantageously holds LED dies sorted into a plurality of wavelength bins (e.g., blue LED dies with different wavelengths lying within the blue region of the electromagnetic spectrum) and phosphor chips sorted into a plurality of phosphor chip types (e.g., phosphor chips that contain different concentrations of yellow phosphor, different types of yellow phosphor and/or that have different thicknesses). A control system to control the pick-and-place system can include an interface, a memory, and a processor coupled to the interface. The interface is operable to receive input specifying an emitter configuration and a color bin to be associated with the emitter. The emitter configuration can specify a number of LED locations on an emitter substrate, with each LED location being associated with one of a number of independently addressable groups of LEDs. The memory is operable to store data associating each of a plurality of source regions in a color space with a selection of an LED wavelength and a phosphor chip type. The processor is operable to establish, based on the input, an association of each of the independently addressable groups of LEDs with one of the source regions such that different independently addressable groups are associated with different and non-overlapping source regions; to determine, based on the data stored in the memory, an LED wavelength and a phosphor chip type for each of the locations on the emitter substrate; and to direct operation of the pick-and-place system such that the pick-and-place system selects, for each location, an LED die having the determined LED wavelength and a phosphor chip having the determined phosphor chip type. For example, the processor can first determine the LED wavelength and subsequently determine the phosphor chip type based on the LED wavelength, the data stored in the memory and the source region associations. In some embodiments, the control system can also control additional tools to electrically connect the LEDs to the emitter substrate.

The following detailed description together with the accompanying drawings will provide a better understanding of the nature and advantages of the present invention.

### BRIEF DESCRIPTION OF THE DRAWINGS

FIG. 1A is a simplified cross-sectional side view of an LED-based lamp with a tunable emitter according to an embodiment of the present invention.
FIG. 1B is a close-up view of the emitter substrate of the lamp of FIG. 1A according to an embodiment of the present invention.
FIG. 1C is a top view of an emitter substrate that can be used in the lamp of FIG. 1A according to an embodiment of the present invention.
FIG. 1D is a top view of another emitter substrate that can be used in the lamp of FIG. 1A according to an embodiment of the present invention.
FIG. 2 is a simplified schematic illustrating electrical connectivity that can be used to provide independent addressability of warm white and cool white LEDs.
FIGs. 3A-3B are color-space graphs illustrate tuning of lamps and in particular the effect of constraining LEDs to a particular source region according to an embodiment of the present invention.
FIG. 4 is a color-space graph illustrating tuning to multiple color bins according to an embodiment of the present invention.
FIG. 5A is a table illustrating measurement data for LEDs with phosphor chips according to an embodiment of the present invention.
FIG. 5B is a table illustrating a lookup table that can be constructed using the data of FIG. 5A according to an embodiment of the present invention.
FIG. 6 is a simplified view of an apparatus for assembling emitters according to an embodiment of the present invention.
FIG. 7 is a simplified block diagram of a computer-based control system for the apparatus of FIG. 6 according to an embodiment of the present invention.
FIG. 8 is a flow diagram of a process for assembling LEDs and phosphors onto an emitter according to an embodiment of the present invention.
FIG. 9 is a flow diagram of a process for assembling LEDs and phosphors onto an emitter according to another embodiment of the present invention.
FIG. 10 is a top-view of an LED emitter package according to an embodiment of the present invention.
FIG. 11 is a top view of an LED emitter package according to another embodiment of the present invention.
FIG. 12 is a top view of an LED arrangement according to still another embodiment of the present invention.
FIG. 13 is a color-space graph illustrating source regions for the emitter of FIG. 12 according to an embodiment of the present invention.

### DETAILED DESCRIPTION

Embodiments of the present invention relate to an emitter for an LED-based lighting device that has multiple groups of LEDs that are independently addressable, allowing the emitter to be tuned to a desired color bin (e.g., a specific white color) by adjusting the relative current supplied to different groups. Improved control over tunability of the emitter is achieved by selecting LED dies and a phosphor chip for each LED die such that each die/phosphor combination produces light in a desired source region associated with the group to which the LED belongs. The source regions are selected such that they do not overlap with each other in color space and such that the desired color bin is intermediate between the source regions. Robotic pick-and-place systems can be used to automate assembly of the emitters by selecting LED dies based on known spectral properties (e.g., peak wavelength) and phosphor chips from a number of distinct phosphor chip types.

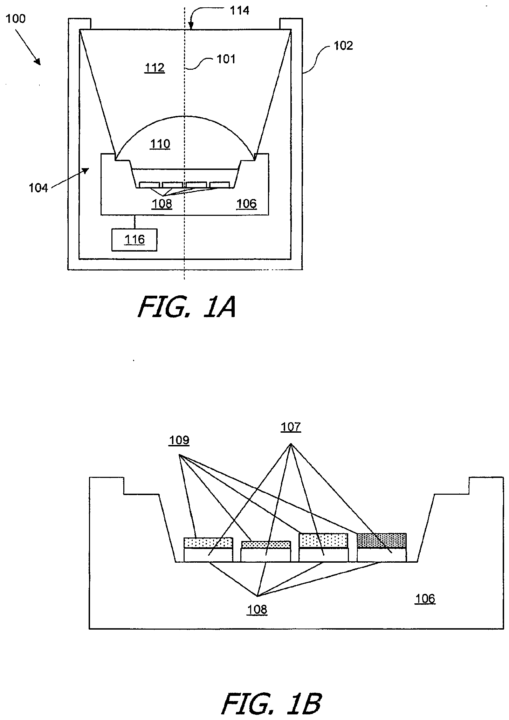

Multi-LED tunable emitters can be incorporated into a variety of lamps. FIG. 1A is a simplified cross-sectional side view of an LED-based lamp 100 with a tunable emitter according to an embodiment of the present invention. Lamp 100, which can be cylindrical about an axis 101 (other shapes can also be used), has a housing 102, which can be made of aluminum, other metals, plastic, and/or other suitable material. Housing 102 holds the various components of lamp 100 together and can provide a convenient structure for a user to grip lamp 100 during installation or removal from a light fixture. The exterior of housing 102 can include mechanical and/or electrical fittings (not shown) to secure lamp 100 into a light fixture and/or to provide electrical power for producing light. In some embodiments, housing 102 may include fins or other structures to facilitate dissipation of heat generated during operation of lamp 100.

Within housing 102 is an LED package 104. Package 104 includes a substrate 106 on which are mounted individual LEDs 108. Each LED 108 can be a separate semiconductor die structure fabricated to produce light of a particular color in response to electrical current. In some embodiments, each LED 108 is covered with a material containing a color-shifting phosphor so that LED 108 produces light of a desired color. For example, a blue-emitting LED die can be covered with a material containing a yellow phosphor; the emerging mixture of blue and yellow light is perceived as white light having a particular color temperature.

FIG. 1B is a close-up view of substrate 106 and LEDs 108 according to an embodiment of the present invention. In this embodiment, LEDs 108 have a phosphor "chip" 109 placed on top of each LED die 107. Phosphor chip 109 can be made of an optically transparent solid matrix material in which particles of phosphorescent material ("phosphors") are dispersed. Conventional phosphors can be used, such as YAG (a yellow phosphor) or the like. Different phosphor chips 109 can vary from each other in thickness, in the type and mixture of phosphors, and/or in the concentration (density) of phosphors within the matrix material. (FIG. 1B shows phosphor chips 109 having different thicknesses and different density of dots representing phosphors; the particular mix of phosphors is not distinguished, but it is to be understood that different phosphor chips 109 may contain different mixtures of phosphors.) In some embodiments, sheets of phosphor-containing matrix material can be produced and diced into chips; suitable sheets are produced, for example, by Mitsubishi Chemical Corp.

The surface area of each phosphor chip 109 is advantageously large enough to cover the light-emitting surface (in this example, the top surface) of a single LED die 107 but not large enough to extend over other LED dies 107. This allows the phosphor chip 109 for each LED die 107 to be selected independently of all others. In some embodiments, phosphor chips 109 can be secured to LED dies 107, e.g., using a thin layer or film of an optically transparent adhesive. Mechanical attachments can also be used; for example, a phosphor chip 109 can be formed so as to fit as a cap over an LED die 107.

In operation, each LED die 107 emits light in the blue region of the electromagnetic spectrum (approximately 450-500 nm), and some of that light is shifted to a lower wavelength by interaction with phosphors in phosphor chip 109. With an appropriate choice of phosphor chip 109, the combination of shifted and unshifted light exiting phosphor chip 109 appears to the human eye as white. As described below, phosphor chips 109 and LED dies 107 are advantageously selected such that each die/phosphor produces light in a desired "source" region in color space; different dies/phosphors advantageously produce light in different source regions. As described below, this selection advantageously allows the overall color of light emitted by lamps 100 to be tuned to a desired small region, or "bin," in color space, reliably and with high yield, even if LED dies 108 themselves vary significantly in their light output properties.

Referring again to FIG. 1A, lamp 100 also includes a primary lens 110, which can be made of glass, plastic or other optically transparent material, that is positioned to direct light emitted from LEDs 108 into secondary optics 112. Secondary optics 112 advantageously include a total-internal-reflection (TIR) lens that also provides mixing of the colors of light emitted from LEDs 108 such that the light beam exiting through front face 114 has a uniform color. Examples of suitable lenses are described in U.S. Patent Application Pub. No. 2010/0091491; other color-mixing lens designs may also be used.

In some embodiments, lamp 100 also includes a control circuit 116 that controls the power provided from an external power source (not shown) to LEDs 108. As described below, control circuit 116 advantageously allows different amounts of power to be supplied to different LEDs 108.

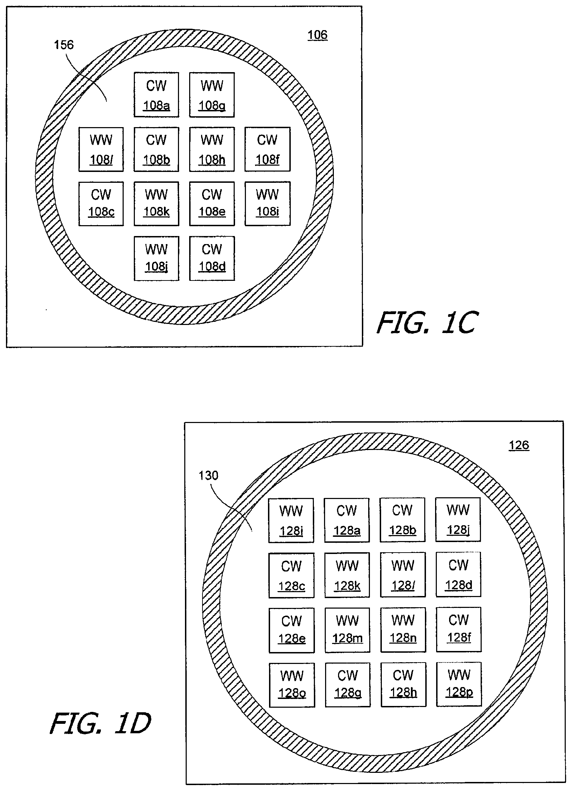

In some embodiments LEDs 108 advantageously include both "warm" and "cool" white LEDs. (The classification of an LED as "warm white" or "cool white" should be understood to include the effect of the phosphor chip 109 covering the LED die 107.) An example is illustrated in FIG. 1C, which is a top view of substrate 106 according to an embodiment of the present invention. As shown, twelve LEDs 108a-*l* are arranged within a recess 156 on substrate 106. Six of the LEDs are cool white ("CW") LEDs 108a-f; the other six are warm white ("WW") LEDs 108g-*l*. "Cool" white and "warm" white, as used herein, refer to the color temperature of the light produced. Cool white, for example, can correspond to a color temperature above, e.g., about 4000 K, while warm white can correspond to a color temperature below, e.g., about 3000 K. It is desirable that cool white LEDs 108a-f have a color temperature cooler than a target color temperature for lamp 100 while warm white LEDs 108g-*l* have a color temperature warmer than the target color temperature. When light from cool white LEDs 108a-f and warm white LEDs 108g-*l* is mixed by mixing lens 112, the target color temperature can be achieved. More generally, for purposes of providing a tunable lamp, the lamp can include LEDs belonging to any number of "groups," with each group being defined as producing light within a different "source region" in color space, where a source region can be defined by reference to a color temperature or a range of color-space coordinates (e.g., (x, y) coordinates in CIE color space). The source regions associated with the warm white and cool white groups advantageously do not overlap, and the desired color bin to which the lamp will be tuned is advantageously intermediate between the source regions associated with the groups of LEDs.

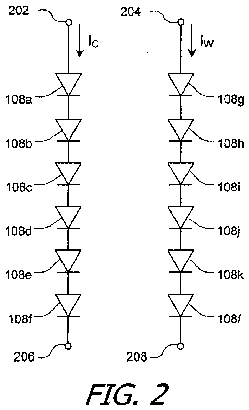

To allow the lamp to be tuned to the desired color bin, the LEDs 108 of lamp 100 are advantageously connected such that cool white LEDs 108a-f and warm white LEDs 108g-*l* are independently addressable, i.e., different currents can be supplied to different groups of LEDs. FIG. 2 is a simplified schematic illustrating electrical connectivity that can be used to provide independent addressability of warm white and cool white LEDs. These electrical connections can be implemented, e.g., using traces disposed on the surface of substrate 106 and/or between electrically insulating layers of substrate 106.

FIG. 1D is a top view showing an arrangement of LEDs on a substrate 126 that can be used instead of the arrangement of FIG. 1C. As shown, sixteen LEDs 128a-p are arranged within a recess 130 on substrate 126. Eight of the LEDs are cool white LEDs 128a-h; the other eight are warm white LEDs 128i-p. It is desirable that cool white LEDs 128a-h have a color temperature cooler than a target color temperature for lamp 100 while warm white LEDs 128i-p have a color temperature warmer than the target color temperature. When light from cool white LEDs 128a-h and warm white LEDs 128i-p is mixed by mixing lens 112, the target color temperature can be achieved. Additional examples of substrates that provide independent addressability for groups of LEDs are described in U.S. Patent App. Pub. No. 2010/0259930; other substrates can also be used.

In some embodiments, such as those shown in FIGs. 1C and 1D, the LEDs are arranged to provide a roughly uniform circular distribution of cool white and warm white LEDs. That is, the cool white and warm white LEDs are intermixed and arranged such that warm and cool light can be produced in approximately equal intensities across different parts of the emitter substrate. This allows for optimal mixing using secondary optics such as TIR lens 112 of FIG. 1A.

In FIG. 2, cool white LEDs 108a-f are connected in series between a first input node 202 and a first output node 204; warm white LEDs 108g-*l* are connected in series between a second input node 206 and a second output node 204. Consequently, one current (*I_{C}*) can be delivered to cool white LEDs 108a-f while a different current (*I_{W}*) is delivered to warm white LEDs 108g-*l*. The currents *I_{C}* and *I_{W}* can be independently controlled, thereby allowing the relative brightness of cool white LEDs 108a-f and warm white LEDs 108g-*l* to be controlled; this provides control over the color of light produced by lamp 100. For example, control circuit 116 (FIG. 1A) can be connected to nodes 202 and 206 and to nodes 204 and 208 to deliver the desired currents *I_{C}* and *I_{W}.* (With reference to FIG. 1D, similar connections can be made for cool white LEDs 128a-h and warm white LEDs 128i-p.)

Other addressing schemes can also be used; for example, each of the LEDS 108a-*l* can be independently addressable. In some embodiments, LEDs 108 can be electrically connected to form three or more independently addressable groups. (Examples of configurations with more than two groups are described below.)

It will be appreciated that lamp 100 described herein is illustrative and that variations and modifications are possible. In one embodiment, lamp 100 can be similar to a LuxSpot™ lamp, manufactured and sold by LedEngin Inc., assignee of the present invention. Those skilled in the art with access to the present teachings will recognize that embodiments described herein can be implemented in a variety of lamps; thus, details of the lamp are not critical to understanding the present invention.

A lamp with a tunable emitter (such as that shown in FIGs. 1A-1C) can be tuned to produce light in a desired white color bin by adjusting the relative current supplied to different groups of LEDs, which (as described above) produce light in different source regions in color space. Examples of techniques for tuning a lamp are described in commonly-assigned co-pending U.S. Patent Application No. 13/106,808. Such techniques are effective as long as the desired white color bin is intermediate in color space between the source regions associated with the different groups of LEDs. Embodiments of the present invention relate to controlling the source regions such that this condition will be satisfied with high reliability for relatively small white color bins. In particular, an LED die and associated phosphor chip can be selected for each position on an emitter substrate (e.g., substrate 106 of FIG. 1C) such that the color produced by that die/phosphor-chip combination is in a well-controlled source region.

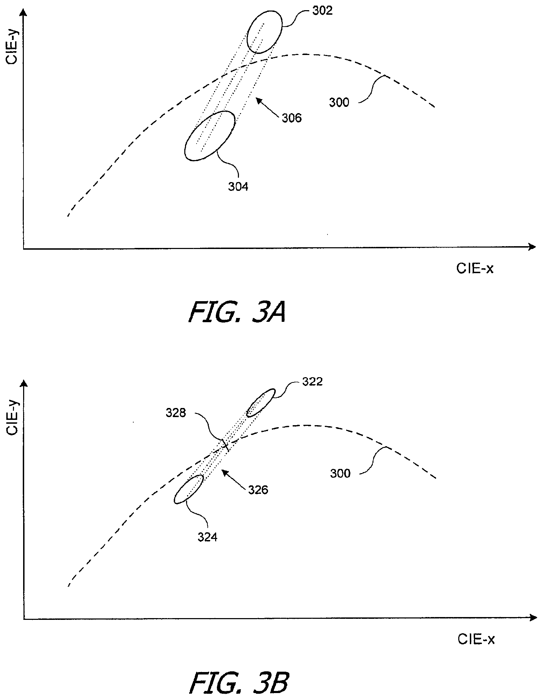

Constraining the individual LEDs in an emitter to a particular source region can improve the ability to tune a lamp incorporating the emitter to a small color bin. FIGs. 3A-3B are color-space graphs illustrate tuning of lamps and in particular the effect of constraining LEDs to a particular source region. FIG. 3A is a graph representing a portion of CIE color space; the blackbody curve is shown at 300. Ellipse 302 represents a source region in color space that may be occupied by the "warm white" LED groups in various lamps 100, and ellipse 304 represents a source region in color space that may be occupied by "cool white" LED groups in the same lamps. In this example, it is assumed that no particular care was taken to select LEDs and phosphors so as to constrain the size of the source region. Dotted lines 306 represent, for various possible lamps, the approximate locus of points in color space to which a particular lamp can be tuned. Any lamp can be tuned to a point near blackbody curve 300, but different points on curve 300 correspond to different white-light color temperatures, and these differences are perceptible to the human eye.

FIG. 3B is a graph similar to that of FIG. 3A. However, in this instance, source regions 322 and 324 are reduced in size (compared to regions 302 and 304 in FIG. 3A) due to the effect of individually selecting the phosphor chips and LED dies for a lamp using techniques described herein. In this example, the LED dies and associated phosphor chips for a warm white group can be individually selected such that each LED produces light within region 322, while the LED dies and associated phosphor chips for a cool white group are individually selected such that each LED produces light within region 324. Dotted lines 326 represent, for various possible lamps, the approximate locus of points in color space to which a particular lamp can be tuned. As the graph indicates, all lamps with LED groups in source regions 322 and 324 can be tuned to a very small range of the blackbody curve, e.g., to points along line segment 328. (Line segment 328 is roughly normal to blackbody curve 300; in some embodiments, tuning to line segment 328 is preferable to following the blackbody curve because the human eye is less sensitive to deviations in the direction of line segment 328 than to deviations along blackbody curve 300.) Thus, selection of individual LED dies and phosphor chips to be used in a particular emitter provides a greater degree of control over the tuning of a lamp in which the emitter is used. Looked at another way, FIG. 3B can be viewed as defining acceptable source regions 322, 324 in color space for LEDs in a lamp that is to be tuned to line segment (or "bin") 328, and the selection process entails selecting LED-die/phosphor-chip combinations that will produce light in the desired source regions.

The particular source regions selected depend in part on the desired properties of the lamps to be produced. In general, the source regions for a lamp (e.g., regions 322, 324) can be selected based on the desired color bin (e.g., bin 328). The source regions are advantageously selected such that they do not overlap with each other or with the desired color bin, which should be intermediate between them. The source regions advantageously have the property that intermediate between any two points in the source regions is a point within the desired color bin; this is indicated by dotted lines 326. In the example of FIG. 3B, regions 322, 324 are elliptical, and the desired size of bin 328 can operate to limit the length of the minor axis. In some embodiments, it is desirable that the source regions be selected such that for most lamps, tuning to the desired color bin is achieved under conditions where the LEDs in different groups receive approximately equal current, as this generally results in brighter lamps. In the example of FIG. 3B, this consideration can operate to limit the length of the major axis of elliptical regions 322, 324.

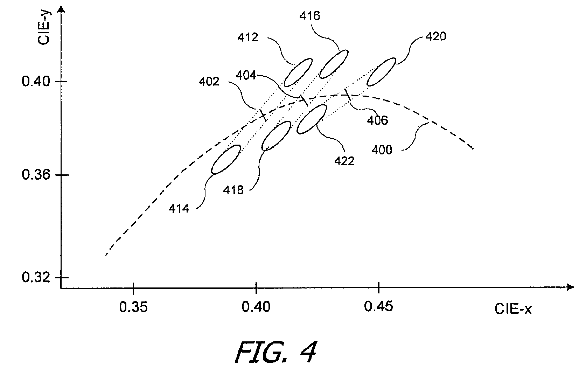

In some embodiments, this principle of source-region selection can be extended to produce different lamps that are tunable to multiple different color bins, with each bin being regarded as a single white color. By way of illustration, FIG. 4 is a color-space graph similar to that of FIGs. 3A and 3B. Here, different lamps can be tuned to any one of three different bins (line segments 402, 404, 406 represent the bins) along blackbody curve 400. Thus, one lamp can have LED dies and phosphor chips selected such that its warm white LEDs produce light in region 412 while its cool white LEDs produce light in region 414; this lamp can be tuned to bin 402. Similarly, another lamp can have LED dies and phosphor chips selected such that its warm white LEDs produce light in region 416 while its cool white LEDs produce light in region 418; this lamp can be tuned to bin 404. And a third lamp can have LED dies and phosphor chips selected such that its warm white LEDs produce light in region 420 while its cool white LEDs produce light in region 422; this lamp can be tuned to bin 406. (In one example, bin 402 would be associated with a warm white lamp, bin 404 with a neutral white, and bin 406 with a cool white.) Thus, to produce a lamp that can be tuned to a particular white color bin, one selects the LED dies and phosphor chips for the warm white and cool white groups such that they produce light in the desired source regions. Any number of bins can be defined, and the source regions associated with different white color bins may or may not overlap. In this example, bins 402, 404, 406 are approximately on blackbody curve 400, while source regions 412, 414, 416,418, 420, 422 are either above or below blackbody curve 400.

Selection of the individual LED dies and phosphor chips for an emitter can be highly automated because the effect of a particular type of phosphor chip on a particular LED die is predictable from the LED die's spectral characteristics and the particular properties of the phosphor chip that define its type (e.g., thickness, phosphor mix, phosphor concentration).

In some embodiments, for example, phosphor chips are made of a solid matrix material in which phosphors (which can include any phosphorescent chemical) are dispersed. Different chips can include different mixtures and concentrations of phosphors. In some embodiments, where blue LED dies are used, the phosphor mixture can include predominantly yellow phosphor such as YAG (yttrium aluminum garnet) or the like. Smaller amounts of non-yellow phosphors can be added. For example, red phosphor (e.g., CaAlSiN₃-based (CASN) phosphors) can be added for a warmer output light or green phosphor can be added for a cooler output light. Batches of phosphor chips may be made in N different thicknesses, with M different mixtures of phosphors at each thickness (different mixtures might be, e.g., yellow only, 95% yellow plus 5% red, 90% yellow plus 10% red, 95% yellow plus 5% green, etc.) and C different concentrations (relative to the matrix material, e.g., by weight) for each phosphor mixture, for a total of T = N*M*C types of phosphor chip. It is not required that all phosphor mixtures be available at all concentrations or at all thicknesses, as long a number of different phosphor-chip types (with different effects on light) are available.

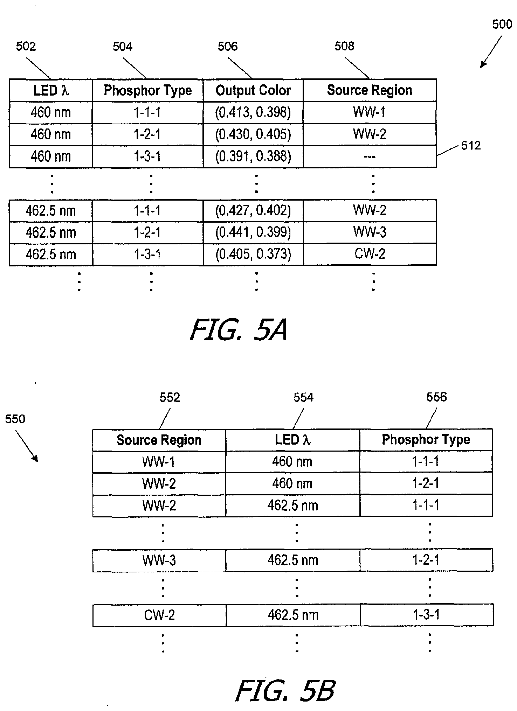

LED dies may be binned according to their spectral characteristics. For example, a given blue LED die produces light over a relatively narrow region, e.g., about 25 nm FWHM, with a peak intensity at a particular wavelength. Due to process variations, the peak wavelength for different LED dies from the same process (e.g., from different parts of a wafer) can vary by 20 nm or more. In some embodiments, the LED dies are binned according to peak wavelength (also referred to herein simply as "the wavelength" of the die). Thus, for example blue LED dies may be binned at 460 nm, 462.5 nm, 464 nm, etc., up to a longest wavelength of, e.g.,. 480 nm. A sampling of LED dies from each bin can be tested with each of the available types of phosphor chips (e.g., T different types) to measure the color-space components of the resulting light. FIG. 5A is a table 500 illustrating measurement results that may be obtained. (In this example, the phosphor type in column 504 is designated using a numerical code *n-m-c* where index *n* represents one of the N possible thicknesses, index m represents one of the M possible phosphor mixtures, and index c represents one of the C possible phosphor concentrations.) In this example, the color of light produced by an LED die from a given wavelength bin (column 502) is measured with each available phosphor type (column 504); color (column 506) can be measured as (*x, y*) coordinates in CIE color space using known instruments and techniques.

The measured color (column 506) is then compared to the source regions for the desired lamp color bins, e.g., the six regions 412, 414, 416, 418, 420, 422 as shown in FIG. 4. If the measured color falls within a source region, that is noted in column 508. (If source regions for different lamp color bins overlap, a particular combination of LED and phosphor may produce light in multiple source regions, and each such region would be noted in column 508.) In some instances, the light color may not be in any source region, as for example, at row 512.

Based on data of the kind shown in FIG. 5A, a lookup table 550 can be constructed in FIG. 5B. This lookup table indicates, for a given source region (column 552), all combinations of LED-die wavelength (column 554) and phosphor-chip type (column 556) that will produce light in that region. Combinations that do not produce light in any of the source regions (such as the combination in row 512 of FIG. 5A) can be omitted from lookup table 550.

Lookup table 550 can be used to automate the selection and assembly process for an emitter. For example, a computer-controlled robotic assembly system can be programmed to produce emitters for lamps in a given color bin, e.g., bin 404 of FIG. 4. The system can be programmed with the information that, for bin 404, the warm white LEDs should all be in source region 416 (which may correspond to region "WW-2" in the notation of FIGs. 5A-5B) while the cool white LEDs should all be in source region 418 (which may correspond to region "CW-2" in the notation of FIGs. 5A-5B). Based on this, the system can determine, via lookup table 550, an appropriate selection of LED dies and phosphor chips and can operate a robotic pick-and-place assembly apparatus to mount the LED dies and phosphor chips at appropriate locations on an emitter substrate.

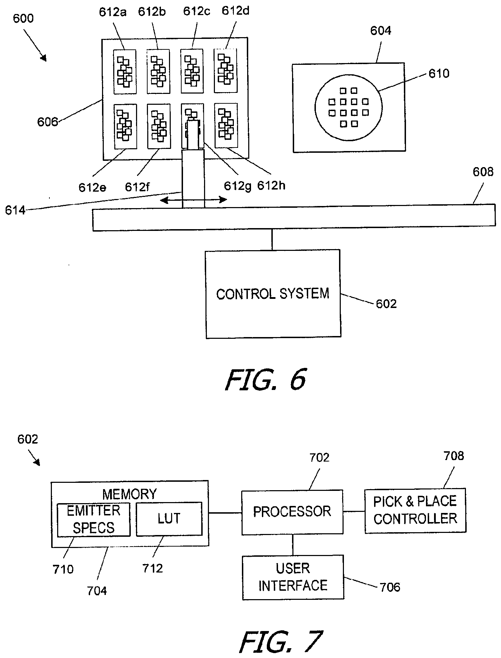

FIG. 6 is a simplified view of an apparatus 600 for assembling emitters according to an embodiment of the present invention. Assembly apparatus 600 includes a control system 602, an emitter stage 604, a component tray 606, and a robotic pick-and-place system 608.

Control system 602 can be a computer system that controls operations of apparatus 600. FIG. 7 is a simplified block diagram of a computer-based control system 602 according to an embodiment of the present invention. In this embodiment, control system 602 includes a processor 702, a memory 704, a user interface 706, and a pick-and-place controller 708.

Processor 702 can include any type of microprocessor, microcontroller, or application-specific integrated circuit capable of performing control operations as described herein in response to input.

Memory 704 can include any computer-readable storage media, including magnetic disk, optical disk, SRAM, DRAM, flash memory, etc. Memory 704 can be used to store program code for execution by processor 702 as well as data such as emitter specifications 710 and look-up table 712 (which can be an implementation of lookup table 550 of FIG. 5B).

User interface 706 can include standard interface components, such as a keyboard, mouse, track ball, track pad, touch pad, display screen, printer, etc., along with associated software executed by processor 702 to control and communicate with the interface components. Via user interface 706, a user can communicate with control system 602 to control operation thereof. For example, the user can control starting and stopping of an assembly process, for example selecting emitter configurations and source regions in color space for the LED groups; examples are described below.

Pick-and-place controller 708 can include a combination of hardware and/or software components that provide a control interface between processor 702 and pick-and-place system 608 of Fig 6. For example, in response to signals from processor 702, pick-and-place controller 708 can control actuators in pick-and-place system 608 to effect the selection and placement of components onto an emitter as described below. Controller 708 can be of conventional design.

Referring again to FIG. 6, emitter stage 604 can be any structure capable of holding an emitter substrate 610 in a specific orientation relative to control system 602. In some embodiments, emitter stage 604 can provide a platform on which an emitter can be placed; the platform can include alignment or keying features to control the position and/or orientation of emitter substrate 610 so that the LED locations are in known positions.

Component tray 606 holds components, including LED dies and/or phosphor chips, that are available for placement onto emitter substrates. In some embodiments, component tray 606 can be segmented into sections 612, with each section holding a specific type of component. Thus, for example, section 612a may hold LED dies in the 460-nm (peak) wavelength bin, section 612b may hold LED dies in the 462.5-nm bin; section 612e may hold phosphor chips of a first type, section 612f may hold phosphor chips of a second type, and so on. The number of sections 612 may be considerably larger than shown, enough to accommodate the total number of distinct die wavelength bins and phosphor-chip types. In some embodiments, the LED dies and phosphor chips may be held in separate trays.

Pick-and-place system 608 can incorporate a robotic assembly that includes a movable arm 614. Conventional robotic systems can be used. Movable arm 614 is advantageously capable of selecting a component from one of the sections 612 of tray 606 and placing that component in a desired location (e.g., one of positions 616) on emitter substrate 610. Operation of movable arm 614 is advantageously directed by control system 602 based on lookup table 712, emitter specifications 710, and instructions from the user as to the desired color bin of the lamp(s) in which the emitters will be included.

It will be appreciated that the assembly apparatus described herein is illustrative and that variations and modifications are possible. Additional automated components can be provided. For example, an automated robotic assembly can place an emitter substrate 610 on stage 604 for LED die and phosphor chip attachment and remove substrate 610 after LED die and phosphor chip attachment are completed. Wire-bonding apparatus or the like can be provided to establish electrical connections between the LEDs and emitter substrate 610. Additional apparatus can apply adhesive to the top surfaces of the LED dies prior to placement of the phosphor chips thereon. In some embodiments, the emitter assembly process can be fully automated, facilitating high-volume production of emitters for a single color bin. Further, emitter assembly apparatus 600 or the like can be implemented as part of a larger production line for lamps, and the production line can be fully or partially automated as desired. In some embodiments, control system 602 may provide additional functionality, such as tracking inventory based on parts selected and used; notifying a user of low inventory, mechanical problems, or other error conditions; and so on.

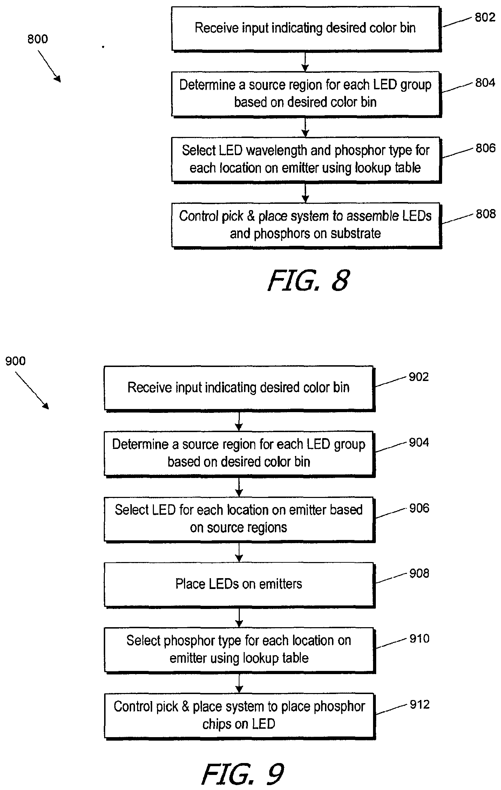

FIG. 8 is a flow diagram of a process 800 for assembling LED dies and phosphor chips onto an emitter according to an embodiment of the present invention. Process 800 can be implemented, e.g., in control system 602 of apparatus 600.

At block 802, input is received indicating a desired color bin. This input can refer to the color of light to be produced by a lamp in which the emitter is intended ultimately to be included. For example, with reference to FIG. 4, the input can select one of bins 402, 404, 406. In some embodiments, the bin-selection input is provided by a user operating user interface 706 of system 602 (FIG. 7), and the user can from time to time change the selection. In some embodiments, the input may also indicate the emitter configuration. For example, apparatus 600 can be operated by a manufacturer that produces a number of different tunable emitters that vary in size, number of LEDs, number of independently addressable groups of LEDs, and arrangement of LEDs; user input may be requested to specify the particular emitter configuration being produced at a given time.

At block 804, a source region for each LED group is determined. As described above, for a given color bin and emitter configuration (in particular the number of independently-addressable groups of LEDs), a source region in color space for each group can be determined. Thus, for example, if bin 404 in FIG. 4 is selected, the source regions would be regions 416 for the warm white LED group and 418 for the cool white LED group.

In some embodiments, emitter specifications 710 (FIG. 7) can include, for each emitter configuration, the number and location of the LEDs in each group and a mapping indicating, for a given lamp color bin, the source region to be used for selecting LEDs for each group. Block 804 can include reading specifications 710 from memory.

At block 806, an LED-die wavelength and phosphor-chip type for each location on the emitter can be selected, e.g., using lookup table 712 (FIG. 7) and the source regions identified at block 804. For example, given the emitter configuration of FIG. 1C and the selection of bin 404 of FIG. 4, it can be determined, e.g., based on emitter specifications 710, that LEDs 108a-f need to produce light in region 418 in color space while LED 108g-ℓ need to produce light in region 416 in color space. Then, referring to lookup table 550 of FIG. 5B and assuming that "WW-2" refers to region 416 while "CW-2" refers to region 418, suitable choices of LED-die wavelengths and phosphor-chip types can be determined.

In some cases, multiple combinations of LED-die wavelength and phosphor-chip type may produce light in the desired source region (as is the case for region WW-2 in FIG. 5B). Where this occurs, selection rules may be put into place to choose one specific combination. For example, the selection may be based on inventory levels of different LED dies (e.g., use the LED die wavelength with the largest number of available units), cost considerations (e.g., some phosphor-chip types may be cheaper to manufacture than others), or other practical considerations. In some embodiments, one combination may be preferable to others on performance grounds; for example, for a given LED die, a thinner phosphor chip with a higher concentration of phosphor material may produce brighter light than a thicker phosphor chip with a lower concentration of the same phosphor material, even though both combinations produce output light in the same source region in color space. Such differences, where known, can be used to define selection rules (e.g., prefer the brighter light).

At block 808, pick-and-place system 608 is controlled to assemble the LED dies and phosphor chips onto the emitter substrate. For example, pick-and-place controller 708 of FIG. 7 can drive pick-and-place system 608 such that arm 614 picks up a component from the appropriate section of tray 612 and places it in the desired location on emitter 610. In some embodiments, block 808 may also include operating other automated assembly components. For example, in one embodiment, the LED dies are placed first, followed by a wire-bonding step to establish electrical connections to the emitter substrate, followed by application of an adhesive to the top surfaces of the LED dies, after which the phosphor chips can be placed. In some embodiments, the assembly steps are implemented using fully automated (e.g., robotic) systems; in other embodiments, some or all of the assembly steps can be performed manually.

In other embodiments, selection of LED-die wavelengths and phosphor-chip types can be separated into different process stages. FIG. 9 is a flow diagram of a process 900 according to an embodiment of the present invention in which LED-die wavelengths are selected first, then a phosphor-chip type is selected for each LED die.

At block 902, input is received indicating a desired color bin, and at block 904, a source region for each independently-addressable LED group in the emitter is determined based on the desired color bin. These blocks can be similar or identical to blocks 802 and 804 of process 800 described above.

At block 906, an LED die is selected for each location on the emitter based on the source regions. In this embodiment, a lookup table may be provided that specifies an LED-die wavelength to use for each source region. In some instances, multiple LED-die wavelengths may be associated with a single source region, and selection rules (e.g., as described above) can be used to determine which LED-die wavelength(s) will be used in a given instance.

At block 908 the selected LED dies are placed on the emitter substrate. Block 908 may include establishing electrical connections to the emitter substrate, e.g., via wire-bonding.

At block 910, a phosphor-chip type for each LED die is determined based the known source region and LED-die wavelength; a lookup table can be used. As long as the LED-die wavelength for each LED die on the emitter is known, an appropriate phosphor-chip type can be selected based on the desired source region.

At block 912, pick-and-place system 608 is controlled to place a phosphor chips of appropriate type onto each LED die. As noted above, this block can include applying adhesives or otherwise securing a selected phosphor chip to each LED die.

It will be appreciated that the assembly process described herein is illustrative and that variations and modifications are possible. Steps described as sequential may be executed in parallel, order of steps may be varied, and steps may be modified, combined, added or omitted.

In some embodiments, phosphor chips can be attached to the LED dies before the LED dies are attached to the emitter. Thus, for example, each section 612 of component tray 606 may contain LED/phosphor subassemblies (i.e., LED dies with phosphor chips already attached); each section can contain LED dies of a particular wavelength with attached phosphor chips of a particular type. An appropriate selection can be made using a lookup table similar to table 550 of FIG. 5B. It should be noted that in such embodiments, it is not necessary to manufacture all possible combinations of LED-die wavelength and phosphor-chip type; the available combinations can be limited to those that are within the source region for at least one lamp color bin. Another option is to store, in each section 612 of component tray 606, LED/phosphor subassemblies that produce light in a given source region; control system 602 can determine the source regions and select LED/phosphor subassemblies from the appropriate section 612. In this case, LED dies of different wavelength may be in the same section 612, as long as the attached phosphor chip results in light in the desired source region.

In the foregoing description, reference is made to embodiments with two groups of LEDs (warm white and cool white), but those skilled in the art with access to the present disclosure will appreciate that the invention is not limited to this specific case. As described in above-referenced U.S. Patent Application No. 13/106,808, tuning can be performed for emitters with more than two independently-addressable groups of LEDs. Where there are more than two groups, each group can be associated with a source region for purposes of selecting LED dies and phosphor chips as described above. For reliable tuning behavior, the source regions associated with different groups advantageously do not overlap, and the lamp color bin is intermediate in color space between the source regions.

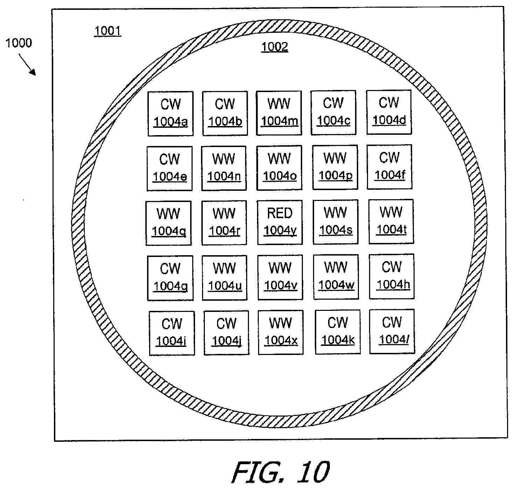

In some embodiments, the groups may include two or more different white groups plus one or more non-white (e.g., red or green) groups. By way of illustration, FIG. 10 is a top-view of an LED emitter package 1000, in which a substrate 1001 has a recess 1002. Within recess 1002 are mounted twelve cool white (CW) LEDs 1004a-*l*, six warm white (WW) LEDs 1004m-x, and one red LED 1004y, arranged as shown, thus providing three groups of LEDs. Those skilled in the art will appreciate that the number of LEDs in each group and/or the arrangement of LEDs can be modified as desired. Emitter package 1000 can be included in a lamp similar to lamp 100 of FIG. 1 or any other type of lamp. In this example, the control circuitry and electrical couplings are such that the cool-white group, warm-white group, and red group are each independently addressable, and the color of light emitted from the lamp can be tuned by adjusting the relative current delivered to each group. In this example, the red LED "group" includes a single LED, and more generally it is to be understood that a single index-addressable LED can constitute a group. In an alternative embodiment, red LED 1004y can be replaced by a sensor (e.g., an ambient light sensor, infrared sensor, or the like), in which case emitter package 1000 would have two independently-addressable groups of LEDs.

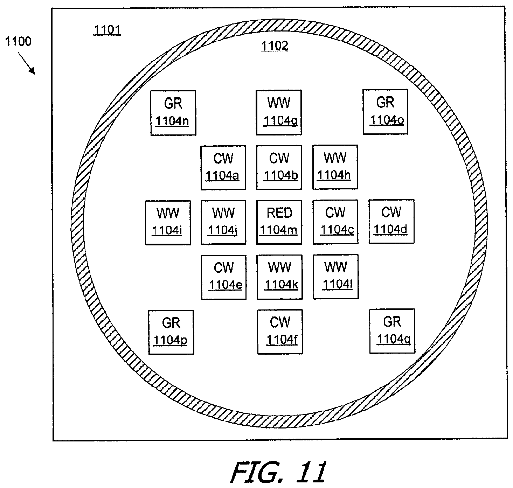

FIG. 11 is a top view of an LED emitter package 1100, in which a substrate 1101 has a recess 1102. Within recess 1102 are mounted six cool white (CW) LEDs 1104a-f, six warm white (WW) LEDs 1104g-ℓ, one red LED 1104m, and four green LEDs 1104n-q, arranged as shown, thus providing four groups of LEDs. Those skilled in the art will appreciate that the number of LEDs in each group and/or the arrangement of LEDs can be modified as desired. Emitter package 1100 can be included in a lamp similar to lamp 100 of FIG. 1 or any other type of lamp. In this example, the control circuitry and electrical couplings are such that the cool-white group, warm-white group, red group, and green group are each independently addressable, and the color of light emitted from the lamp can be tuned by adjusting the relative current delivered to each group. In this example, the red LED "group" includes a single LED, and more generally it is to be understood that a single index-addressable LED can constitute a group.

Red LED 1104m and green LEDs 1104n-q can be conventional, single-color LEDs. As is known in the art, red and green LEDs can be produced with relatively small dispersion in color space. Accordingly, selection of phosphors to produce particular red and green colors need not be done for these groups. Selection of LEDs and phosphors, e.g., using techniques described above, is advantageously performed to control the color-space regions occupied by cool white LEDs 1104a-f and warm white LEDs 1104g-ℓ.

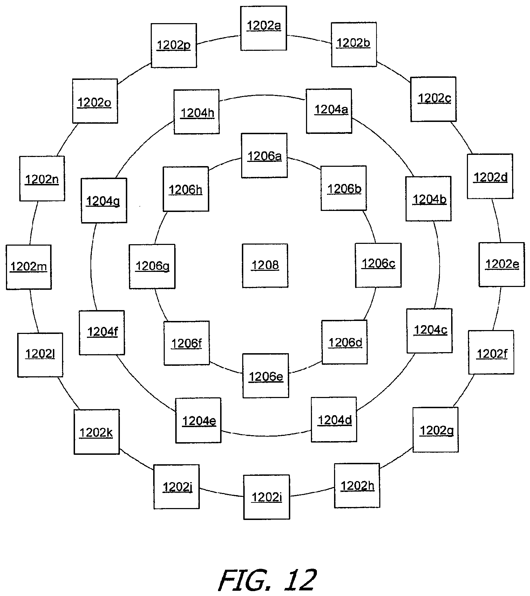

In other embodiments, the independently addressable groups can include more than two groups of white LEDs occupying different source regions in color space, e.g., two different cool white groups and one warm white group. FIG. 12 illustrates one possible arrangement of LEDs. Sixteen LEDs 1202a-p form an independently addressable group of warm white LEDs; eight LEDS 1204a-h form a first independently addressable group of cool white LEDs, and eight more LEDs 1206a-h form a second independently addressable group of cool white LEDs. Center position 1208 can be left vacant, or it can be occupied by a different LED (e.g., a red LED) or a light sensor.

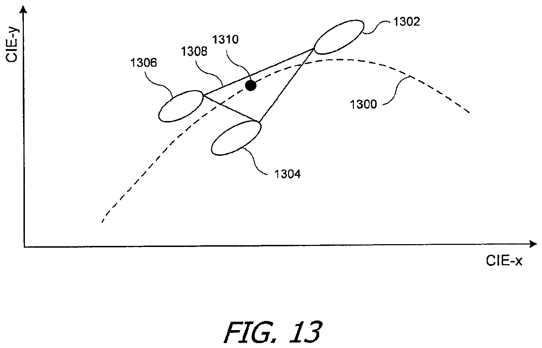

In this example, the two cool white groups can be chosen to lie on opposite sides of the blackbody curve. FIG. 13 is a color-space graph illustrating source regions for the emitter of FIG. 12 in the case where position 1208 is vacant; blackbody curve 1300 is shown for reference. Warm white LEDs 1202a-p can be selected to be in color space region 1302; the first group of cool white LEDs 1204a-h can be selected to be in color space region 1304, and the second group of cool white LEDs 1206a-h can be selected to be in color space region 1306. It will be appreciated that the techniques described above for selecting combinations of LED-die wavelength and phosphor-chip type to be within a desired source region apply equally in this example, even though this embodiment includes more than two source regions.

With these source region selections, it is possible to tune to any point within triangle 1308. For example, point 1310 on blackbody curve 1300 can be the lamp color bin. The source regions can be chosen such that the desired tuning point is where the color contributions from different groups are approximately balanced; this will generally produce the brightest light possible for a particular lamp but is not required.

As described above, selection of the individual phosphor chips and LED dies for an emitter can improve control over the source regions in color space in which the LEDs produce light. This in turn reduces the size of the color bin to which a lamp containing the emitter is tuned, allowing greater uniformity in the color of light from one lamp to the next.

In addition, active selection of individual phosphor chips and LED dies can reduce manufacturing costs as compared to standard techniques where the same phosphor mixture, thickness, and concentration is used for all LEDs. For example, given that blue LED dies in particular can vary significantly in wavelength (due to the manufacturing process), the ability to adjust an LED to a desired color by selecting a suitable phosphor on a per-die basis allows a larger fraction of manufactured LED dies to be used; this in turn can reduce production costs to the extent that fewer LED dies are discarded as unusable.

The use of multiple source regions in a single lamp allows source regions to be larger (in color space) than the single color bins to which the lamps are ultimately tuned. This can also help to expand the fraction of LED dies that can be used for further savings in production cost. For typical blue LED production processes, sufficient color control to allow all LED wavelengths to "hit" at least one useful source region can be achieved with a manageable number of phosphor-chip types, e.g., a dozen or so.

The phosphor chips used can be manufactured using existing processes that provide sufficient control over thickness and phosphor density to provide a predictable response for phosphor chips of a given type. Thus, the emitter manufacturing process need not include a color-test of the light. Instead, once it has been determined that a particular LED-die wavelength and phosphor-chip type produce a given light color, that knowledge can be relied on during manufacture. Quality-control testing of emitters can accordingly be limited to merely testing that the LEDs turn on when power is supplied. (Color testing may still be performed at a later stage, e.g., as part of color tuning of the lamp.)

Phosphor chips are also well suited for use with existing pick-and-place systems, thus allowing the manufacturing process to be highly automated. Further, the use of discrete phosphor chips is results in highly controllable application of a desired quantity and concentration of phosphors on each LED die so that light of a desired color can reliably be produced. The deliberate variation between different phosphor-chip types can advantageously be used to control for the variation in LED-die wavelength that occurs as a result of LED die manufacturing processes; with a suitable range of phosphor-chip options many LED dies with different wavelengths can be tuned to a desired region in color space.

While the invention has been described with respect to specific embodiments, one skilled in the art will recognize that numerous modifications are possible. For example, the invention is not limited to a particular lamp geometry or form factor or as to the number and type of LEDs. The number of groups of LEDs, number of LEDs in any group, and/or the color of a group can be varied. The LEDs can be arranged as desired; the examples shown in FIGs. 1C, 1D, and 10-12 illustrate a uniform circular distribution of the groups that can facilitate mixing of the different colored light from different groups (e.g., using optical elements) so as to produce a uniform color at the output of a lamp, although this is not required.

In general, an emitter for a tunable lamp will include at least two groups of LEDs, with each group producing light in a different source region in color space. The size of the source regions can be adjusted to provide a desired degree of control over the color bin of the resulting lamp. The source regions associated with different groups are advantageously chosen such that the regions do not overlap and the desired (tuned) color for light produced by the lamp is intermediate between the source regions. In some embodiments, the source regions are selected such that tuning to the desired color bin is achieved when nearly equal currents are supplied to the various groups, as this tends to result in maximizing brightness of the lamp.

Embodiments described above use peak wavelength to characterize the light produced by an LED die. Other embodiments may use other parameters, such as a combination of peak wavelength and a spectral width parameter (e.g., full width at half maximum intensity (FWHM)). Any spectral characteristic or combination of spectral characteristics can be used to sort the LED dies into bins, and the LED dies may be binned coarsely or finely as desired. Embodiments are not limited to any particular number of LED-die bins or phosphor-chip types.

Although the present description specifically refers to combinations of blue LED dies with phosphor chips containing predominantly yellow phosphors to produce white light, those skilled in the art will appreciate that other color combinations may be used. Phosphor chips can be made of various materials, with any mixture and concentration of phosphorescent material, and used together with a variety of LED dies of different wavelengths or colors.

Thus, although the invention has been described with respect to specific embodiments, it will be appreciated that the invention is intended to cover all modifications and equivalents within the scope of the following claims.

## Claims

1. A light-emitting device (104) comprising:
a substrate (106);
a plurality of LED dies (108) arranged on a surface of the substrate (106), wherein the LED dies (108) are electrically connected to form at least two independently addressable groups of LEDs, the groups of LEDs including a first group of LEDs (108 g-1) to produce light whose color is in a first region of a color space and a second group of LEDs (108 a-f) to produce light whose color is in a second region of the color space, wherein the first region and the second region are non-overlapping regions; and
a plurality of phosphor chips (109), each of the phosphor chips (109) being disposed to cover a light-emitting surface of a different one of the LED dies (108), wherein the phosphor chip covering each of the LED dies (108) is selected based on the peak wavelength of light produced by the LED die and the color of the light to be produced by the group in which the LED die is included, wherein multiple combinations of LED die wavelength and phosphor chip type produce light in at least one of the first region or second region.

2. The light-emitting device of claim 1, wherein the at least two independently addressable groups of LEDs receive approximately equal current.

3. The light-emitting device of claim 1 wherein the first color is a warm white color and the second color is a cool white color.

4. The light-emitting device of claim 2 wherein the groups of LEDs further include a third group to produce light of a third color, wherein the third color is a warm white color that is different from the second color.

5. The light-emitting device of claim 2 wherein the groups of LEDs further include a third group to produce light of a third color, wherein the third color is a red color or a green color.

6. The light-emitting device of claim 2 wherein the LED dies produce light having blue wavelengths and the phosphor chips contain a yellow phosphor.

7. The light-emitting device of claim 1 wherein at least two of the phosphor chips differ from each other in at least one of chip thickness, concentration of phosphorescent material, or mixture of phosphorescent material.

8. A method for making a light-emitting device, the method comprising:
determining a color bin for the light-emitting device;
providing an emitter substrate having a plurality of locations for connecting light-emitting diodes (LEDs), wherein the emitter substrate provides electrical connections between the locations such that the locations are arranged into at least two independently addressable groups;
for at least two of the independently addressable groups, selecting a different source region in a color space to be associated with the independently addressable group such that the color bin is intermediate between the different source regions in the color space and the different source regions are non-overlapping with each other;
selecting, for each of the plurality of LED locations on the emitter substrate an LED die from a plurality of LED die bins, and a phosphor chip from a plurality of phosphor chip bins such that the LED die and the phosphor chip together produce light in the source region associated with the independently addressable group to which the LED location belongs, wherein multiple combinations of LED die wavelength and phosphor chip type produce light in at least one of the first region or second region; and
mounting the selected LED dies and phosphor chips on the emitter substrate at the LED locations.

9. The method of claim 8 wherein the source regions include a warm white region and a cool white region.

10. The method of claim 9 wherein the LED dies produce light having blue wavelengths and the phosphor chips contain at least a yellow phosphor.

11. The method of claim 8 wherein selecting the LED dies and the phosphor chips includes selecting a phosphor chip type from a plurality of phosphor chip types, wherein at least two of the phosphor chip types differ from each other in at least one of chip thickness, concentration of phosphor material, or mixture of phosphor material.

12. The method of claim 8 wherein the plurality of LED die bins correspond to different peak wavelengths between 460 nm and 480 nm.

13. The method of claim 8 wherein attaching the selected LED dies and phosphor chips to the emitter substrate includes operating a pick-and-place system to place the selected LED dies and phosphor chips onto the emitter substrate.

14. The method of claim 8 wherein attaching the selected LED dies and phosphor chips to the emitter substrate includes:
placing the selected LED dies on the emitter substrate at the LED locations;
establishing electrical connections between the LED dies and the emitter substrate; and
attaching the selected phosphor chips to the LED dies.

15. The method of claim 14 wherein attaching the selected phosphor chips to the LED dies includes applying an adhesive to a top surface of each of the LED dies and placing each phosphor chip on the adhesive.

## Patentansprüche

1. Licht-emittierende Vorrichtung (104), die aufweist:
ein Substrat (106),
eine Mehrzahl von LED-Plättchen (108), die auf einer Fläche des Substrats (106) arrangiert sind, wobei die LED- Plättchen (108) elektrisch verbunden sind, um zumindest zwei unabhängig adressierbare Gruppen von LEDs zu bilden, wobei die Gruppen von LEDs eine erste Gruppe von LEDs (108 g-l), um Licht zu erzeugen, dessen Farbe in einem ersten Bereich eines Farbraums ist, und eine zweite Gruppe von LEDs (108 a-f), um Licht zu erzeugen, dessen Farbe in einem zweiten Bereich des Farbraums ist, enthalten, wobei der erste Bereich und der zweite Bereich nicht überlappende Bereiche sind, und
eine Mehrzahl von Phosphorchips (109), wobei jeder der Phosphorchips (109) angeordnet ist, um eine Licht-emittierende Fläche eines verschiedenen der LED-Plättchen (108) zu bedecken, wobei der Phosphorchip, der jedes der LED- Plättchen (108) bedeckt, auf Grundlage der Spitzenwellenlänge des Lichts, das durch das LED-Plättchen erzeugt wird, und der Farbe des Lichts, das durch die Gruppe erzeugt werden soll, in der der LED- Plättchen enthalten ist, ausgewählt wird, wobei mehrere Kombinationen von einer LED- Plättchen-Wellenlänge und einer Phosphorchipart Licht in zumindest einem der Bereiche, erster Bereich und zweiter Bereich, erzeugen.

2. Licht-emittierende Vorrichtung nach Anspruch 1, wobei die zumindest zwei unabhängig adressierbaren Gruppen von LEDs ungefähr den gleichen Strom erhalten.

3. Licht-emittierende Vorrichtung nach Anspruch 1, wobei die erste Farbe eine warme weiße Farbe ist und die zweite Farbe eine kalte weiße Farbe ist.

4. Licht-emittierende Vorrichtung nach Anspruch 2, wobei die Gruppen der LEDs außerdem eine dritte Gruppe enthalten, um Licht einer dritten Farbe zu erzeugen, wobei die dritte Farbe eine warme weiße Farbe ist, die von der zweiten Farbe verschieden ist.

5. Licht-emittierende Vorrichtung nach Anspruch 2, wobei die Gruppen von LEDs außerdem eine dritte Gruppe von LEDs enthalten, die Licht einer dritten Farbe erzeugt, wobei die dritte Farbe eine rote Farbe oder eine grüne Farbe ist.

6. Licht-emittierende Vorrichtung nach Anspruch 2, wobei die LED- Plättchen Licht erzeugen, das blaue Wellenlängen hat, und die Phosphorchips einen gelben Phosphor enthalten.

7. Licht-emittierende Vorrichtung nach Anspruch 1, wobei zumindest zwei der Phosphorchips sich bei zumindest einer der Größen, Chipdicke, Konzentration des phosphoreszierenden Materials oder Mischung des phosphoreszierenden Materials, voneinander unterscheiden.

8. Verfahren zum Herstellen einer Licht-emittierenden Vorrichtung, wobei das Verfahren aufweist:
Bestimmen eines Farb-Bins für die Licht-emittierende Vorrichtung,
Bereitstellen eines Emittersubstrats, das eine Mehrzahl von Orten zum Verbinden von Licht-emittierenden Dioden (LEDs) hat, wobei das Emittersubstrat elektrische Verbindungen zwischen den Orten vorsieht, so dass die Orte in zumindest zwei unabhängig adressierbaren Gruppen arrangiert sind,
für zumindest zwei unabhängig adressierbare Gruppen, Auswählen eines verschiedenen Quellbereichs in einem Farbraum, um mit der unabhängig adressierbaren Gruppe assoziiert zu sein, so dass der Farb-Bin zwischen den verschiedenen Quellbereichen in dem Farbraum dazwischenliegend ist und die verschiedenen Quellbereiche nicht überlappend miteinander sind,
Auswählen, für jeden aus der Mehrzahl von LED-Orten auf dem Emittersubstrat, eines LED- Plättchens aus einer Mehrzahl von LED-Plättchen -Bins und eines Phosphorchips aus einer Mehrzahl von Phosphorchip-Bins, so dass das LED-Plättchen und der Phosphorchip zusammen Licht in dem Quellbereich erzeugen, der mit den unabhängig adressierbaren Gruppen assoziiert ist, wozu der LED-Ort gehört, wobei mehrere Kombinationen von einer LED-Plättchen-Wellenlänge und einer Phosphorchipart Licht in zumindest einem der Bereiche, erster Bereich und zweiter Bereich, erzeugen, und
Montieren der ausgewählten LED-Plättchen und Phosphorchips auf dem Emittersubstrat an den LED-Orten.

9. Verfahren nach Anspruch 8, wobei die Quellbereiche einen warmen weißen Bereich und einen kalten weißen Bereich enthalten.

10. Verfahren nach Anspruch 9, wobei die LED-Plättchen Licht, das blaue Wellenlängen hat, erzeugen und die Phosphorchips zumindest ein gelbes Phosphor beinhalten.

11. Verfahren nach Anspruch 8, wobei das Auswählen der LED-Plättchen und der Phosphorchips ein Auswählen einer Phosphorchipart aus einer Mehrzahl von Phosphorchiparten enthält, wobei zumindest zwei der Phosphorchiparten sich bei zumindest einer der Größen, Chipdicke, Konzentration des Phosphormaterials oder Mischung des Phosphormaterials, voneinander unterscheiden.

12. Verfahren nach Anspruch 8, wobei die Mehrzahl der LED-Plättchen-Bins sich auf verschiedene Spitzenwellenlängen zwischen 460 nm und 480 nm bezieht.

13. Verfahren nach Anspruch 8, wobei Befestigen der ausgewählten LED-Plättchen und Phosphorchips an dem Emittersubstrat ein Betreiben eines Pick-And-Place-Systems enthält, um die ausgewählten LED-Plättchen und Phosphorchips auf dem Emittersubstrat zu platzieren.

14. Verfahren nach Anspruch 8, wobei Befestigen der ausgewählten LED-Plättchen und Phosphorchips an dem Emittersubstrat enthält:
Platzieren der ausgewählten LED-Plättchen auf dem Emittersubstrat an den LED-Orten,
Herstellen elektrischer Verbindungen zwischen den LED-Plättchen und dem Emittersubstrat, und
Befestigen der ausgewählten Phosphorchips an den LED-Plättchen.

15. Verfahren nach Anspruch 14, wobei Befestigen der ausgewählten Phosphorchips an den LED-Plättchen ein Anwenden eines Klebstoffs auf einer oberen Fläche von jedem der LED-Plättchen und Platzieren jedes Phosphorchips auf dem Klebstoff enthält.

## Revendications

1. Dispositif luminescent (104) comprenant :
un substrat (106) ;
une pluralité de microplaquettes DELs (108) agencées sur une surface du substrat (106), dans lequel les microplaquettes DELs (108) sont reliées électriquement pour former au moins deux groupes de DELs adressables indépendamment, le groupe de DELs comportant un premier groupe de DELs (108 g-l) pour produire de la lumière dont la couleur est dans une première région d'un espace colorimétrique et un deuxième groupe de DELs (108 a-f) pour produire de la lumière dont la couleur est dans une deuxième région de l'espace colorimétrique, dans lequel la première région et la deuxième région sont des régions non-chevauchantes ; et
une pluralité de puces au phosphore (100), chacune des puces au phosphore (109) étant disposée pour recouvrir une surface luminescente d'une autre microplaquette DEL (108), dans lequel la puce au phosphore recouvrant chacune des microplaquettes DELs (108) est sélectionnée en fonction de la longueur d'onde maximale de lumière produite par la microplaquette DEL et la couleur de la lumière à produire par le groupe comportant la microplaquette DEL, dans lequel de multiples combinaisons de longueur d'onde de microplaquette DEL et de type de puce au phosphore produisent de la lumière dans au moins une des première ou deuxième régions.

2. Dispositif luminescent selon la revendication 1, dans lequel les au moins deux groupes de DELs adressables indépendamment reçoivent un courant électrique à peu près égal.

3. Dispositif luminescent selon la revendication 1, dans lequel la première couleur est une couleur blanc chaud et la deuxième couleur est une couleur blanc froid.

4. Dispositif luminescent selon la revendication 2, dans lequel les groupes de DELs comportent en outre un troisième groupe pour produire de la lumière d'une troisième couleur, dans lequel la troisième couleur est une couleur blanc chaud différente de la deuxième couleur.

5. Dispositif luminescent selon la revendication 2, dans lequel les groupes de DELs comportent en outre un troisième groupe pour produire de la couleur d'une troisième couleur, dans lequel la troisième couleur est une couleur rouge ou une couleur verte.

6. Dispositif luminescent selon la revendication 2, dans lequel les microplaquettes DELs produisent de la lumière présentant des longueurs d'onde du bleu et les puces au phosphore contiennent un phosphore jaune.

7. Dispositif luminescent selon la revendication 1, dans lequel au moins deux des puces au phosphore diffèrent l'une de l'autre sur au moins une caractéristique parmi leur épaisseur de puce, leur concentration de matériau phosphorescent, ou leur mélange de matériau phosphorescent.

8. Procédé de fabrication d'un dispositif luminescent, le procédé comprenant :
la détermination d'une classe de couleur pour le dispositif luminescent ;
l'apport d'un substrat émetteur présentant une pluralité d'emplacements pour relier les diodes électroluminescentes (DELs), dans lequel le substrat émetteur fournit des liaisons électriques entre les emplacements de sorte que les emplacements soient agencés dans au moins deux groupes adressables indépendamment ;
pour au moins deux groupes adressables indépendamment, la sélection d'une région source différente dans un espace colorimétrique à associer au groupe adressable indépendamment de sorte que la classe de couleur soit intermédiaire entre les différentes régions sources dans l'espace colorimétrique et que les différentes régions sources ne se superposent pas;
la sélection, pour chaque emplacement parmi la pluralité d'emplacements de DEL sur le substrat émetteur, d'une microplaquette DEL à partir de la pluralité de classes de microplaquette DEL, et d'une puce au phosphore à partir de la pluralité de classes de puce au phosphore de sorte que la microplaquette DEL et la puce au phosphore produisent ensemble de la lumière dans la région source associée au groupe adressable indépendamment auquel l'emplacement de DEL appartient, dans lequel de multiples combinaisons de longueur d'onde de microplaquette DEL et de type de puce au phosphore produisent de la lumière dans au moins une région parmi la première région et la deuxième région ; et
l'assemblage des microplaquettes DELs et des puces au phosphore sélectionnées sur le substrat émetteur aux emplacements de DEL.

9. Procédé selon la revendication 8 dans lequel les régions sources comportent une région blanc chaud et une région blanc froid.

10. Procédé selon la revendication 9 dans lequel les microplaquettes DELs produisent de la lumière présentant des longueurs d'onde du bleu et les puces au phosphore contiennent au moins un phosphore jaune.

11. Procédé selon la revendication 8 dans lequel la sélection des microplaquettes DELs et des puces au phosphore implique la sélection d'un type de puce au phosphore à partir d'une pluralité de types de puces au phosphore, dans lequel au moins deux des types de puces au phosphore diffèrent l'un de l'autre sur au moins une caractéristique parmi leur épaisseur de puce, leur concentration de matériau phosphorescent, ou leur mélange de matériau phosphorescent.

12. Procédé selon la revendication 8, dans lequel la pluralité de classes de microplaquettes DELs correspond à différentes longueurs d'onde pic entre 460nm et 480nm.

13. Procédé selon la revendication 8 dans lequel la fixation des microplaquettes DELs et puces au phosphore sélectionnées sur le substrat émetteur comporte l'actionnement d'un système de manutention (« pick-and-place ») pour placer les microplaquettes DELs et puces au phosphore sélectionnées sur le substrat émetteur.

14. Procédé selon la revendication 8 dans lequel la fixation des microplaquettes DELs et puces au phosphore sélectionnées sur le substrat émetteur comporte :
la mise en place des microplaquettes DELs sélectionnées sur le substrat émetteur aux emplacements de DEL ;
la création de liaisons électriques entre les microplaquettes DELs et le substrat émetteur ; et
la fixation des puces au phosphore sélectionnées sur les microplaquettes DELs.

15. Procédé selon la revendication 14 dans lequel la fixation des puces au phosphore sélectionnées sur les microplaquettes DELs implique l'application d'un adhésif sur une surface supérieure de chacune des microplaquettes DELs et la mise en place de chaque puce au phosphore sur l'adhésif.
